# EUROPEAN PATENT SPECIFICATION

(11) **EP 2 458 694 B1**
(45) Date of publication and mention of the grant of the patent: **26.06.2013**
(21) Application number: 10192412.4
(22) Date of filing: 24.11.2010
(51) Int. Cl.: H01R 4/10, H01R 43/04, H05K 3/32

(54) **Terminal assembly and method for connecting an electric wire to a terminal element**
Anschlussanordnung und Verfahren zum Verbinden einer Leiters an ein Anschlusselement
Ensemble de connexion et procédé pour connecter un fil électrique à un élément du connexion

(43) Date of publication of application: 30.05.2012
(73) Proprietor: Tyco Electronics Nederland B.V., 5222 AR 's-Hertogenbosch (NL)
(72) Inventor: Van Tilburg, Jan, 5345GJ, Oss (NL); Scheefhals, Fred, 5283ME, Boxtel (NL)
(74) Representative: Grünecker, Kinkeldey, Stockmair & Schwanhäusser

(56) References cited:
- WO-A1-90/01817
- FR-A- 1 049 522
- FR-A- 1 279 798
- FR-A1- 2 935 550
- GB-A- 1 505 676
- US-A- 3 355 698

## Description

The present invention relates to a method for mechanically and electrically connecting an electric wire to a terminal element comprising: arranging a connecting portion of the electric wire substantially parallel to an entrance surface of a contact opening of said terminal element, and contacting a joining section of the connecting portion that is provided with an insulating coating with the contact opening by plastically deforming the joining section into the contact opening, whereby an insulating coating of the wire is removed in the joining section during contacting the joining section with the contact opening. The present invention further relates to a terminal assembly comprising a terminal element having at least one contact opening, and at least one electric wire that is provided with an insulating coating and is mechanically and electrically connected to the contact opening, wherein a connecting portion of the electric wire that is located outside the contact opening and runs substantially parallel to an entrance surface of the contact opening, and wherein a joining section of the connecting portion is plastically deformed into and thereby non-positively connected to the contact opening wherein the insulating coating of the wire is removed in the joining section during contacting the joining section with the contact opening.

The present invention further relates to a method for producing an electrical device comprising the method for mechanically and electrically connecting an electric wire to a terminal element according to the present invention, as well as an electrical device comprising a terminal assembly according to the present invention.

In electric components and electrical devices, such as connectors, USB cables and the like, an electric wire or cable is mechanically and electrically connected to a terminal element or connector. One way for mechanically and electrically connecting the wire to the terminal element that is used in consumer assemblies and is common for printed circuit board terminals is to solder the wire to the terminal element.

However, soldering technology is difficult to automate. Further, stacking different wires to one terminal, such as a connector of a PCB, is limited due to the pitch required for keeping the adjacent soldering positions apart from each other. A soldering connection may also be problematic in respect of the connection's mechanical stability and reliability, in particular when the terminal assembly is subjected to rough environmental conditions, e.g. in consumer devices such as USB charger cables.

Reliable types of connection for the terminal assembly are crimped connectors. Crimped connectors are commonly provided with corresponding piercing tines that are used as penetration connectors for contacting the electric conductors, such as flexible flat cables or flexible printed circuit boards.

However, a crimp connector has to be specifically designed with piercing tines or other specific protrusions that are plastically deformed during the crimping process for mechanically fixing the wire to the connector. Further, the electric connection may be troublesome to achieve in crimped connectors. This makes automation of crimp connectors difficult, and the specfic design of said connectors raises their costs.

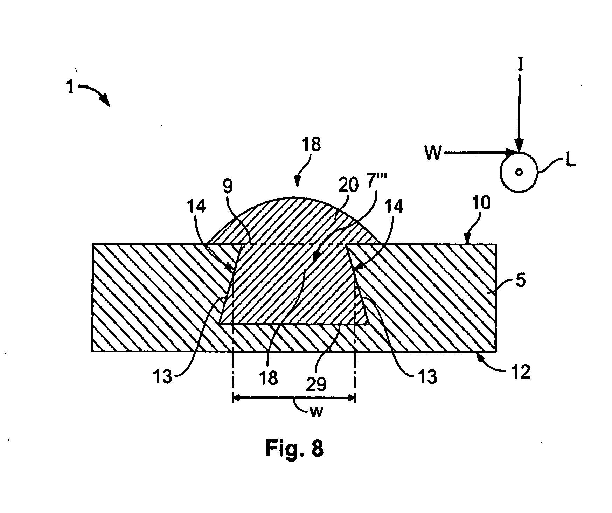

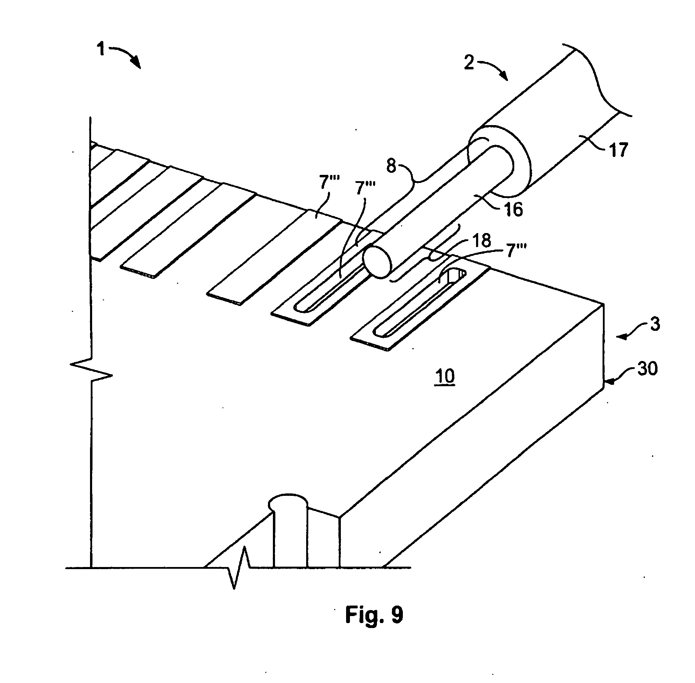

FR 1 279 798 A on which the preamble of claims 1 and 6 is based discloses contracting a joining section of a wire with a contact groove by pressing the joining section into the connecting groove thereby plastically deforming the lateral cut of the joining section. The insulating coating of the wire during contact of the joining section with the contact opening in Figures 8 and 9.

FR 1 049 522 A discloses to contact a wire with a terminal having a contact opening by placing the wire in the opening having protrusions and plastically deforming the protrusions around the wire for contacting.

GB 1 505 676 A discloses contacting the connecting portion of an electric wire with the contact opening of a terminal, said contact opening being designed as a through-hole having an undercut designed as a cavity forming a dent.

FR 2 935 550 A1 discloses contacting a joining section of a connection portion of a wire with the contact opening of a terminal by plastically deforming the lateral cut of the joining section. The contact opening is designed as a rectangular through-hole.

Documents WO 90/01817 A1 and US 3,355,698 A disclose crimping a connection portion of an electric wire with the contact opening of a terminal element designed as a groove.

In view of the above, the object of the present invention is to provide an improved terminal assembly and an improved method for mechanically and electrically connecting an electric wire to the terminal element, that is cheap and simple, is easy to automate, and at the same time, provides a stable and reliable connection.

The initially mentioned method solves the above problem by the contact opening being formed by a through-hole extending from the entrance surface on one side of the terminal element to an exit surface on another side of the terminal element, wherein the contact opening is provided with at least one undercut designed as at least one cavity forming a dent, in which the contact opening is widened, and the insulation at the one side is kept connected with the insulation at the other side.

A terminal element in the sense of the present invention refers to the part which forms the portion to which a wire is to be contacted. Preferred examples of a terminal element are a terminal contact, a printed circuit board, a conductive foil and similar devices to which a wire can be contacted. A terminal element can therefore be any device which can be connected with a wire in the sense of the present invention.

The method step of contacting the joining section of the connecting portion with the contact opening is preferably achieved by a pressing step, i.e. by pressing the wire into the contact opening. However, any deforming step suitable to achieve the plastic deformation may be used according to the claimed invention.

The terminal assembly, as initially mentioned, solves the above defined problem in that the contact opening is formed by a through-hole extending from the entrance surface on one side of the terminal element to an exit surface on another side of the terminal element, wherein the contact opening is provided with at least one undercut designed as at least one cavity forming a dent, in which the contact opening is widened, and the insulation at the one side is kept connected with the insulation at the other side..

By arranging the electric wire parallel with the contact opening and then connecting a portion of the wire, namely the joining section with the contact opening, e.g. by pressing the joining section into the contact opening, a mechanically and electrically secure connection can be provided between the electric wire and the terminal element, namely between the joining section of the wire and the contact opening of the terminal element. This way of providing a secure connection is easy to automate and good to control. The plastic deformation of the joining section providers for a reliable non-positive connection with the contact opening. No specific design of the terminal element is required for the connection since the joining section of the wire is plastically deformed. Hence, a simple terminal element can be provided at low cost because no special connecting elements are necessary. Finally, stacking various electrical wires at a low pitch on one terminal element is possible, because the pitch is only limited by the distance at which adjacent contact openings can be produced in the terminal element.

The solution according to the invention may be combined in any way with the following advantageous embodiments of the present invention respectively and further improved.

In a first embodiment of the terminal assembly, the contact opening can be elongated in the direction of the electrical wire. In the method for mechanically and electrically connecting the wire to the terminal element, the connecting portion of the electric wire can be arranged substantially parallel to the entrance surface of the contact opening and also parallel to the longitudinal direction of the contact opening prior to contacting. Upon contacting, the joining section of the connection portion, that is the part of the connection portion that is in alignment with the elongated contact opening is increased. Thereby the contact area between the joining section and the contact opening can be increased. This improves the non-positive connection between the wire and the terminal element.

To further improve the connection between the wire and the terminal element, the contact opening is provided with at least one undercut. The undercut is designed as at least one cavity forming a dent widening the contact opening. In providing the contact opening of the terminal element with an undercut, the joining section of the terminal assembly can be plastically deformed into a form fit connection with the undercut. This further improves the mechanical and electrical connection of the wire with the terminal element. The undercut may be arranged in the direction that is parallel to the entrance surface of the contact opening. Thereby a positive joint against displacing the joining section relative to the contact opening in the plane of the surface entrance can be formed. Additionally, a further undercut may be in the direction perpendicular to the entrance surface securing the joining section in the contact opening against moving the joining section out of the contact opening.

In a further embodiment, the elongated contact opening can be designed as a channel having a substantially rectangular surface entrance. A channel can be easily aligned with the joining section of the electrical wire. Also, such channel can be easily designed with an undercut, for example a channel having protrusions extending from the side walls of the channel into the channel having indentations that section-wise widen the channel. An undercut that is formed in the direction perpendicular to the surface entrance can be formed by, e.g. widening the channel in the direction from the entrance opening to the bottom, e.g. in the form of a dovetail.

The contact opening is formed as a through-hole extending from the entrance surface on one side of the terminal element to an exit surface on another side of the terminal element. For example, an elongated contact opening may thus form an aperture in the form of a slot. Such aperture or through-hole is easy to manufacture, e.g. by punching, because one does not have to take care of the depth of the opening.

Furthermore, a through-hole can improve the non-positive or force-fit connection with an additional form-fit or positive joint since the joining section, that is made of a malleable material deformed upon contacting, can be plastically deformed such that the joining section extends through the through-hole and is formed into a stopper overlaying the entrance surface and the exit surface on both sides of the terminal element. The stopper can be arranged outside the surface opening adjacent to the entrance surface and can be designed such that it extends at least section-wise over the entrance surface. Thereby the stopper can be brought into abutment with the portion of the terminal element surrounding the contact opening in the direction perpendicular to the entrance surface and the exit surface. This can be easily achieved when, during contacting, the joining section outside the contact opening is deformed as overlaying the entrance surface. The stopper may be formed for example by widening a portion of the joining section that remains outside the contact opening. The widening may be performed for example by flattening the joining section in the form of a rivet head, forming a flaring, a flange or bulge extending over the circumference of the entrance/exit surface.

In another embodiment, the volume of the wire in the joining section is greater than the volume of the contact opening. When contacting, e.g. pressing the joining section into the contact opening, the joining section substantially fills up the contact opening. Thereby, the contact area of the force-fit connection is maximized as the entire part of the joining section that is in parallel with the contact opening can be plastically deformed into the contact opening.

In a further embodiment of the method, for contacting, the joining section may be pressed intra the contact opening in an insertion direction that runs substantially perpendicular to the entrance surface of the contact opening. Thereby, the strain applied to the terminal element in the area of the contact opening can be reduced and most of the pressure applied during contacting can be transformed into the plastic deformation of the malleable joining section of the wire. The contact opening being a through-hole, a deformation tool or unit can be used, such as a tool having a first deformation element, e.g. a die pressing the joining section in the insertion direction into the contact opening and a second deformation element, e.g. a further die or anvil that is arranged at the exit of the through-hole. Thereby the joining section can be plastically deformed by pressing it in the insertion direction into the contact opening, filling up the contact opening and flattening or widening the portion of the joining section swelling out of the exit opening and the portion of the joining section that remained outside the entrance of the contact opening into stoppers overlaying the entrance and the exit surface. In this way a form-fit can be provided at the entrance and at the exit of the through-hole.

The wire to be mechanically and electrically connected to the terminal element can be a solid wire, a stranded wire or a magnet wire. As far as the volume of the joining section is greater than the volume of the contact opening, an arbitrary wire can be used. Hence, even flat wires with the necessary volume may be used. Excluded are only flat wires whose cross sectional diameter is too small, that is, wires that do not provide sufficient material to allow plastic deformation to fix the wire into the contact opening. The insulation coating of the wire is removed in the joining section during contacting the joining section with the contact opening. The removal of the insulation coating may be achieved, e.g. by designing the entrance opening such that the insulation coating is scraped off the lead upon the plastic deformation. Such scraping off is for example automatically achieved when the width of the lead or the conductor of the wire in the joining section is smaller than the width of the entrance surface.

The above described terminal assembly can be used in a method for producing an electric device and can be a component of an electric device, such as a USB cable, of the present invention. The above described method of the invention can be part of a method for producing an electric device according to the present invention. For example, the method for producing the electric device can comprise method of forming the terminal assembly of the present invention first. Thereafter, at least one terminal assembly can be plased in or can be arranged at the housing of the device. Optionally, the wires of the the terminal assembly can be twisted, bundled, foiled and/or braided.

The invention is described hereafter by means of example referring to exemplary embodiments with reference to the drawings. The various features of the described embodiments can be combined or omitted independently of one another, as already described above.

In the drawings:
- Fig. 1:: is a schematic perspective view of a terminal assembly not part of invention in the pre-assembled state;
- Fig. 2:: is a schematic perspective view of the terminal assembly of Fig. 1 in the assembled state;
- Fig. 3:: is a schematic perspective view of section A of Fig. 2 showing the crosssectional representation at the sectional line A'-A';
- Fig. 4A and 4B:: are schematic perspective views of a further terminal assembly not part of the invention in the pre-assembled sate (Fig. 4A) and in the assembled state (Fig. 4B);
- Fig. 5A and 5B:: are schematic perspective views of a terminal assembly according to an embodiment in the pre-assembled sate (Fig. 5A) and in the assembled state (Fig. 5B);
- Fig. 6A and 6B:: are schematic perspective views of a terminal assembly according to a second embodiment in the pre-assembled sate (Fig. 6A) and in the assembled state (Fig. 6B);
- Fig. 7A and 7B:: are schematic perspective views of another terminal assembly not part of invention in the pre-assembled state (Fig. 7A) and in the assembled state (Fig. 7B);
- Fig. 8:: is a schematic planar view of a valve of a further of the terminal assembly not part of invention taken along a cross-sectional line corresponding to a crosssectional line A'-A' of Fig. 2;
- Fig. 9:: is another terminal assembly not part of invention in the pre-assembled state; and
- Fig. 10A and 10B:: are schematic perspective views of the terminal assembly of Fig. 9 in the assembled state, wherein in Fig. 10B a part of this terminal assembly is cut off for showing a lateral cut of the terminal assembly corresponding to the cut A'-A' of Fig. 2.

Hereafter preferred embodiments of the terminal assembly 1 and methods for electrically and mechanically connecting an electric wire 2 to the terminal element 3 of said terminal assembly 1 are described with reference to the drawings.

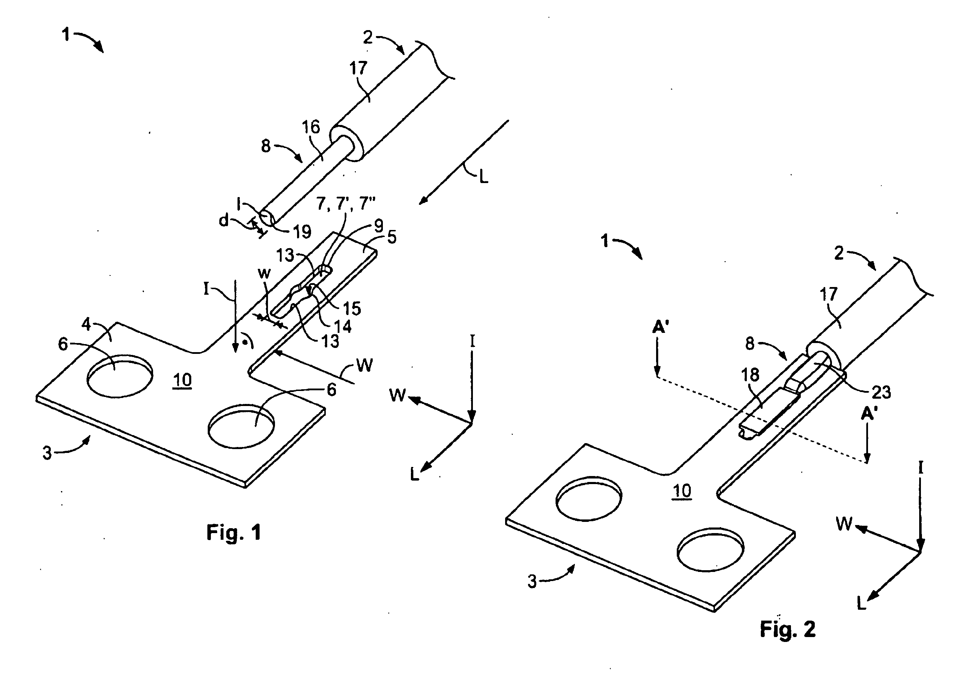

The terminal element 3 shown in Fig. 1 has generally a plate-like structure having a connecting part 4 and a wire attachment or contact portion 5. Hence, the terminal element according to this figure refers to what is generally known as a terminal connector 3. In the following , the terminal element 3 will be referred to as a terminal 3. The terminal 3 has the form of a T-shaped plate, whereby the rectangularly formed contact portion 5 passes into the middle of the connecting part 4 so that the contact portion 5 forms the base and the connecting part 4 forms the cross bar of the T-shaped terminal plate 3 according to the embodiment of Fig. 1.

The connecting part 4 is provided with two attachment holes 6. The attachment holes 6 are designed as through-holes for inserting a bolt or a screw as fastening means for fastening the terminal 3 to an electric apparatus (not shown). The terminal 3 shown in Fig. 1 is made of a material that conducts electricity so that once the electric wire 2 is joined with the contact portion 5 of the terminal 3, the connecting part 4 is electrically connected to the wire 2.

In the contact portion 5, the contact opening 7 is provided. The contact opening 7 is elongated in the longitudinal direction L of the terminal 3. The wire 2 is principally aligned with the longitudinal direction L of the terminal 3, in which longitudinal direction L the contact opening 7 is also elongated. For mechanically and electrically connecting the electric wire 2 to the terminal 3, at least the connecting portion 8 of the wire 2 is aligned parallel to the entrance surface 9 of the contact opening 7, which entrance surface 9 is arranged at the upper side 10 of the terminal 3. Furthermore, the connecting portion 8 of the wire 2, namely the longitudinal axis I of the wire 2 is aligned with the longitudinal direction L of the terminal 3 and the elongated contact opening 7.

In the Fig. 1 to 3, the contact opening 7 is designed as the through-hole 7', extending from the entrance surface 9 at the upper side 10 of the contact portion 5 up to the exit surface 11 at the lower side 12 of the contact portion 5. Due to the elongated shape of the contact opening 7, the through-hole 7' is designed as a slot 7" extending along the longitudinal direction L. The lateral sides 13 of the slot 7" are provided with an undercut 14. In the shown embodiment, the undercut 14 is formed as a cavity 15 forming a dent, in which the width w taken along the width direction W of the contact opening 7 and the terminal 3 is widened. Alternatively, the undercut 14 could be designed by protrusions (not shown) extending from the lateral sides 13 of the slot 7" into the contact opening 7 thereby reducing the width w of the slot 7" at the position of the undercuts 14.

The wire 2 of the Fig. 1 comprises a solid conductor or lead 16 that is covered on the outside with an insulating coating 17 insulating the conductor 16 against the outside.

The connecting portion 8 of the wire 2 is located at one end of the wire 2. In the connecting portion 8, the insulating coating 17 of the wire 2 is removed in the assembly shown in Fig. 1 so that the blank conductor 16 is exposed and can be mechanically and electrically connected to the contact opening 7, as described in the following by example with reference to the terminal assembly according to Figs. 1 to 3.

For mechanically and electrically connecting the wire 2 to the terminal 3, the joining section 18 of the connecting portion 8 is contacted with the contact opening 7. During the contacting step, the joining section 18 is plastically deformed by pressing it into the contact opening 7, in an insertion or press direction I that is substantially perpendicular to the entrance surface 9 and the upper side 10 of the contact portion 5 as well as perpendicular to the longitudinal axis I of the aligned wire 2. By pressing in the insertion direction I, the joining section 18 enters through the entrance surface 9 into the contact opening 7. Thereby the lateral cut 19 of the joining section 18 is plastically deformed since the width w of the contact opening 7 of the entrance surface 9 is smaller than the width w the diameter d of the conductor 16. Since the conductor 16 is made from a malleable material, the joining section 18 is force-fitted into the contact opening 7 by contacting the joining section 18 with the contact opening 7. For ensuring a secure non-positive connection between the wire 2 and the contact opening 7, the lead 16 in the joining section 18 has to be provided with sufficient material to allow plastic deformation achieving a non-positive connection due to plastic deformation of the wire 2.

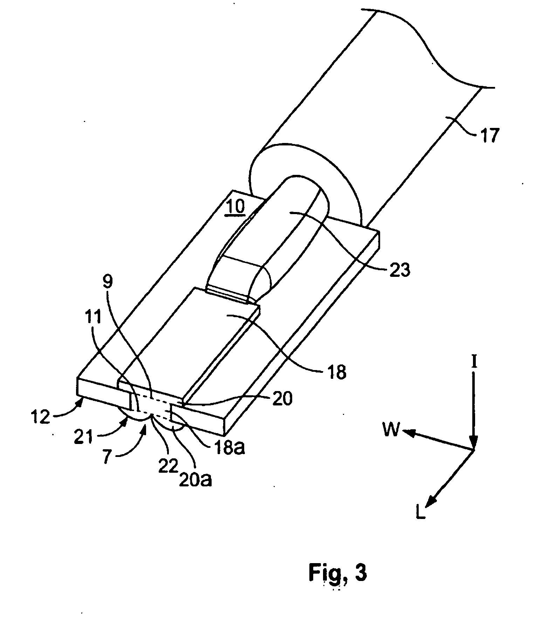

The terminal assembly 1 in the assembled state is shown in Figs. 2 and 3. As can be seen in Fig. 2, the joining section 18, that is that part of the connecting portion 8 of the wire 2 that is aligned with the contact opening 7 and is plastically deformed forming the connection between the wire 2 and the terminal 3, substantially fills up the complete slot 7" that forms a contact opening 7 in the first embodiment. By filling up the complete contact opening 7, the contact area between the deformed joining section 18 and the contact opening 7 is maximized thereby maximizing the force-fit connection between the wire 2 and the contact opening 7.

The contacting step of plastically deforming the joining section 18, in the shown assembly, the step of pressing the conductor 16 into the contact opening 7 to form the joining section 18 can, for example, be conducted by using a deformation or pressing tool (not shown). The pressing tool may comprise a deformation unit (not shown) with a substantially flat surface that presses the connecting portion 8 in the insertion direction I against the contact portion 5 of the terminal 3 having the contact opening 7. The joining section 18 of the wire 2 that is aligned with a contact opening 7 is deformed such that the malleable lead 16 is pressed into the contact opening 7, and through the complete contact opening 7 from its entrance surface 9 to its exit surface 11. After the joining section 18 swells out of the exit surface 11, a counter-deformation unit (not shown) is pressed against the insertion direction I from the lower side 12 of the contact portion 5 against the part of the joining section 18 that swells out of the exit surface 11. By compressing the joining section 18 from the upper side 11 and from the lower side 12, the lateral cut 19 of the joining section 18 is deformed thereby contacting the joining section 18 with the contact opening 7. The part 18a of the joining section 18 that is situated in the contact opening 7 after the contacting step forms the non-positive connection of the wire 2 with the terminal 3 that ensures the mechanical and electrical assembling of the terminal assembly 1. Since the volume of the joining section 18 is greater than the volume of the contact opening 7, a part of the joining section 18 remains outside the contact opening 7 at the upper side 10, which part did not enter the contact opening 7. Another part of the joining section 18 that swelled out of the exit surface 11 is also located outside the contact opening 7 on the lower side 12.

Due to the flat surface of the deformation unit (not shown), pressing the joining section 18 in the insertion direction I from the upper side 10, the portion at the upper side 10 forms a stopper 20 that seals and overlays the entrance surface 9 of the contact opening 7. The stopper 20 on the upper side 10 has the shape of a flat plate and extends, in the width direction W and against the width direction W over the lateral sides 13 of the slot 7', thereby forming a form-fit connection of the joining section 18, securing the wire 2 in the insertion direction I in the contact opening 7.

A similar stopper 20a is formed at the lower side 12 of the contact portion 5. This stopper 20a overlays the exit surface 11 in a similar manner as the stopper 20 overlayers the entrance surface 9 of the upper side 10. Thus, the stopper 20a secures the joining section 18 in a form-fit manner in the contact opening 7 against in the direction opposite to the insertion direction I.

The only difference between the stopper 20 at the upper side 10 and the stopper 20a at the lower side 12 is that the lower stopper 20a has not a substantially planar shape but is rather formed with two bulges 21 and 21'. One of each bulge 21, 21' extends over one of the lateral sides 13 at the exit surface 11 of the contact opening 7. The two bulges 21, 21' meet approximately in the middle of the exit surface 11, so that the stopper 20a at the lower side 12 is provided with a central groove 22. By forming the stopper 20a with two bulges 20, 20' and a middle channel or groove 22, the secure form-fit can be formed even with a minimum amount of material of the joining section 18 swelling out of the exit surface 11 because less material is required in the channel 22 and nearly all the swelling out material can be deformed and pressed in and against the width direction W forming the two bulges 21 and 21'.

As can be seen in Fig. 2, the remainder of the connecting portion 18 that is not aligned with the contact opening 7 and therefore does not form the joining section 18, is pressed against the upper side 10 of the contact portion 5 of the terminal 3 forming a transition section 23 that is located between the joining section 18 and the remaining wire 2 outside the connecting portion. Since the transitions section 23 is not pressed into the contact opening 7, the transition section 23 is flattened, however, remains higher than the stopper 20 of the joining section 18.

In the following, further terminal assemblies 1 are presented. For elements having a similar or identical structure/function as elements of the first shown assembly, the same reference signs are used. In the following, only the differences between the further assemblies 1 with respect to the first assembly shown in Figs. 1 to 3 are described.

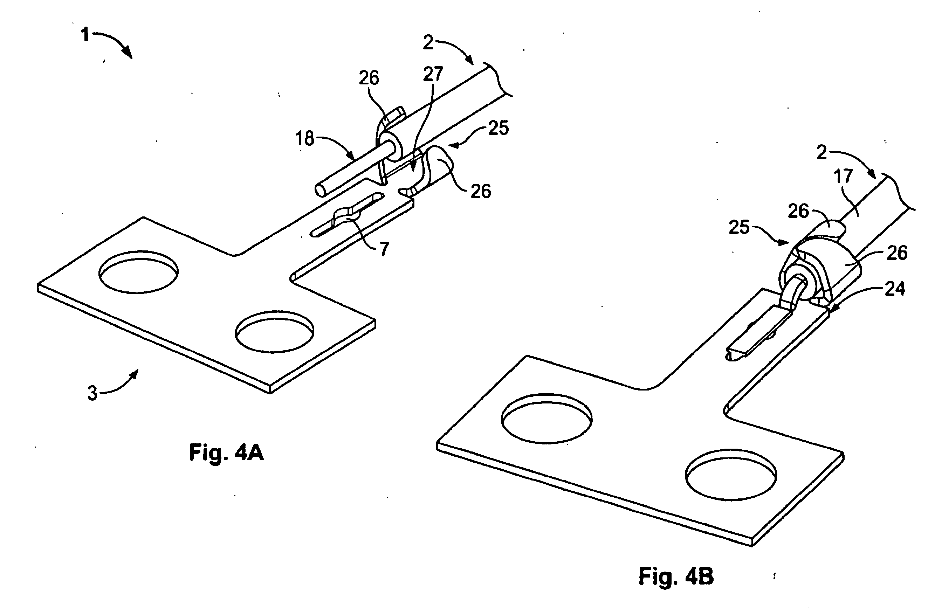

The further terminal assembly 1 is shown in Figs. 4A and 4B. Fig. 4A illustrates the terminal assembly 1 comprising the wire 2 and the terminal element 3 in the pre-assembled state. The assembled state, wherein the wire 2 is contacted to the contact portion 5 of the terminal element 3 can be seen in Fig. 4B.

The terminal assembly 1 of the second assembly principally corresponds to the terminal assembly 1 of the first assembly shown in Figs. 1 to 3.

The only difference is that the connecting portion 5 of the second assembly is at the free end 24, facing away from the connecting portion 4, provided with a crimp barrel 25. The crimp barrel 25 is designed, in the pre-assembled state shown in Fig. 4A, by a pair of crimping pieces 26 arranged in a portion having a substantially U-shaped section. The two crimping pieces 26 form a recess 27, in which the wire 2, having the insulating coating 17 can be introduced when assembling the terminal assembly 1. After insertion of the wire 2 in the recess 27, the crimping pieces 26 are bent with their free ends towards each other embracing and fixing the wire 2 in the recess 27.

By providing the terminal 3 with a crimping barrel 25, an additional joint can be formed between the wire 2 and the terminal element 3. Said additional joint will take up the main load if someone pulls at the wire 2, thereby reducing the tensions at the connection between the joining section 18 and the opening 7.

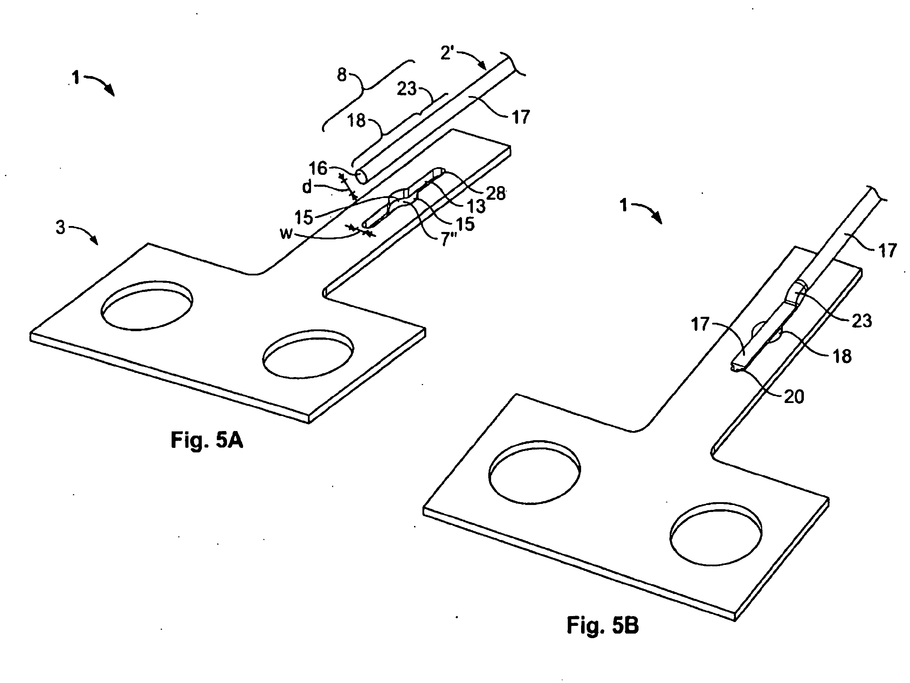

Figs. 5A and 5B illustrate a first embodiment of the terminal assembly 1 having a wire or cable 2 and a terminal element 3. Fig. 5A shows the terminal assembly 1 of the third embodiment in the pre-assembled state. Fig. 5B displays the terminal assembly 1 of the third embodiment in the assembled state, where the wire 2 is mechanically and electrically connected to the terminal element 3.

The terminal element 3 of the first embodiment is identical to the terminal element 3 of the first assembly shown in Figs. 1 to 3.

Contrary to the terminal assembly 1 of the first assembly, the terminal assembly 1 of the first embodiment comprises also a magnet wire 2'. The magnet wire 2' is a wire conductor 16, usually of copper or aluminium, that is covered with a thin insulation 17. The thin insulation 17 of the magnet wire 2' covers the complete lead 16 so that in the pre-assembled state shown in Fig. 5A, the connecting portion 8 is also provided with an insulating coating 17, contrary to the wire 2 of the first assembly.

According to the first embodiment of Figs. 5A and 5B, the insulating coating 17 of the wire 2' is removed in the joining section 18 during the step of contacting the joining section 18 with the contact opening 7. Since the diameter d of the magnet wire 2' is larger than the width w of the slot 7' forming the contact opening 7 of the terminal 3, the insulating coating 17 is removed from the lead 16 in the joining section 18 upon plastically deforming the lateral cut 19 of the joining section 18 when contacting said joining section 18 with the terminal 3.

As can be seen in Fig. 5B, only in those sections of the wire 2' that are wider than the width w of the slot 7', the insulation coating 17 is scraped off and thereby removed, allowing an electrical connection between the lead 16 and the terminal 3. At those sections of the magnet wire 2', that are aligned with the contact opening 7, and do not extend beyond the lateral sides 13 of the slot 7', the insulation 17 remain in place as in these sections, the insulation 17 is not scraped of at the edge 28 of the entrance 9. Therefore, the joining section 18 is still isolated at the stoppers 20 and 20a exposed at the upper side 10 and the lower side 12 of the terminal 3.

Finally, it can be seen in Fig. 5B that the joining section 18, upon filing up the contact opening 7, also fills up the cavities 15 provided at those lateral sides 13 of the slots 7". Thereby, a further form-fit is provided between the joining section 18 and the undercut 14 in the contact opening 7 which secures the joining section 18 against transition of the joining section 18 in and against the longitudinal direction L in the contact opening 7.

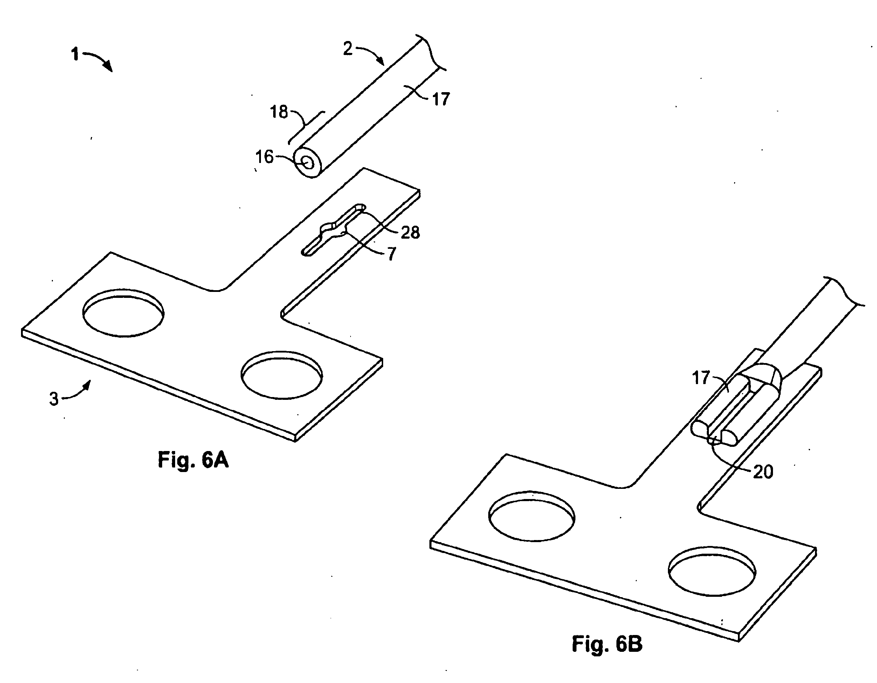

The second embodiment of the terminal assembly 1, that is shown in Figs. 6A (pre-assembled state) and 6B (assembled state) comprises a terminal element 3 that is principally identical to the terminal element 3 of the first and third embodiment. The wire 2 of the terminal assembly 1 is a solid wire 2 similar to the wire 2 of the first assembly. However, contrary to the first assembly, the insulating coating 17 of the wire 2 in the second embodiment extends onto the connecting portion 8 and principally covers the complete lead 16.

Similar to an insulation displacement connector, the terminal 3 of the second embodiment of Figs. 6A and 6B removes the insulation coating 17 in the joining section 18 of the wire 2 upon connecting said joining section 18 with the contact opening 7 of the contact portion 5 of the terminal 3. The edge 28 surrounding the entrance surface 9 at the upper side 10 of the contact portion 5 functions, upon pressing the wire 2 in the insertion direction I against the terminal 3, as a blade that removes the insulation coating 17 in the joining section 18 so that only the lead 16 of the joining section 18 is pressed into the contact opening 7.

In embodiments having a wire 2 that is provided with an insulating coating 17 in the connecting portion 8, a terminal element 3 having a contact opening that is provided with an undercut 14, such as the cavities 15 shown in Fig. 5A, has the additional benefit of keeping the insulation at the upper side 10 of the terminal 3 connected with the cutted insulation at the lower side 12. This avoids pollution in the deformation or pressing tool due to release of the cut insulation into the tool. Further, the insulation remains for the wire 2 on both sides 10 and 12 of the terminal element 3 even in the joining section 18, where the electrical contact is made between the joining section 18 and the contact opening 7.

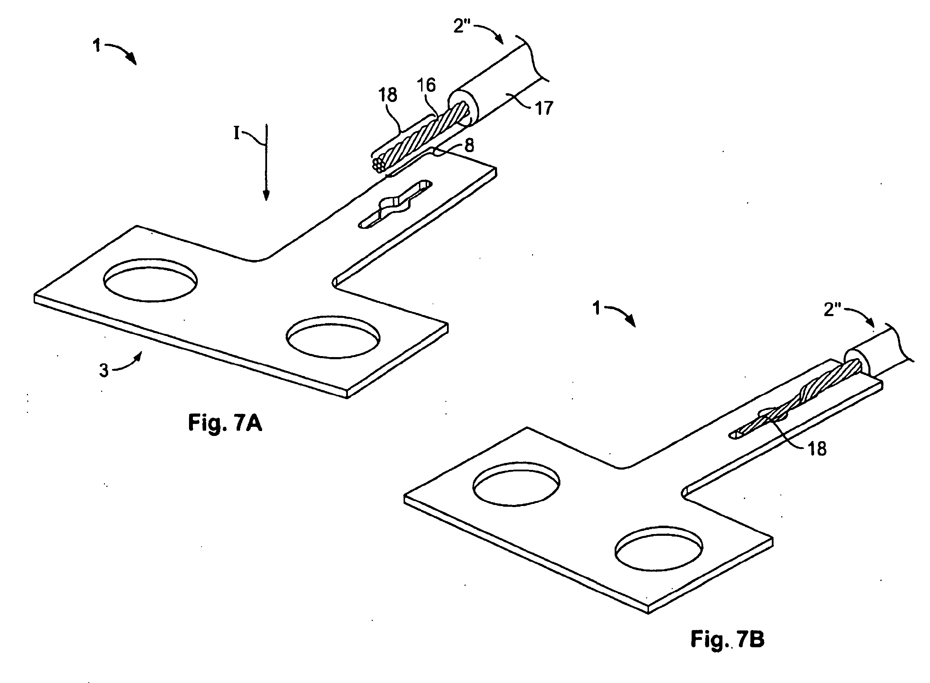

Figs. 7A and 7B show a further terminal assembly 1, not part of invention wherein the pre-assembled state is shown in Fig. 7A and Fig. 7B depicts the assembled state.

The terminal element 3 of the assembly is principally identical to the terminal element 3 of the first assembly. Furthermore, the wire 2" of this assembly principally corresponds to the wire 2 of the first assembly, wherein insulating coating 17 is removed in the connecting portion 8 so that a blank lead 16 is exposed to the outside.

In contrast to the wire 2 of the first assembly, the wire 2" of the assembly of Fig 7A and 7B is a stranded wire that is composed of a bundle of smaller wires making up the conductor.

Fig. 8 is a schematic representation of a cross-sectional view in the width direction w at a position corresponding to the sectional line A'-A' of Fig. 2, through the contact opening 7 of a terminal assembly 1 in the assembled state. As can be seen in Fig. 8, the contact opening 7 in the contact portion 5 of the terminal 3 differs from the contact opening 7 of the previous assemblies in that it is not designed as a through-hole 7'. Rather, the contact opening 7 of the embodiment shown in Fig. 8 is designed as a contact groove or a contact channel 7"' that can be only entered via the entrance surface 9, exposed at the upper side 10 of the contact portion 5. The shape of the entrance surface 9 may be similar to the shape of the entrance 9 in the previous assemblies and can be designed elongated.

Starting from the entrance surface 9, the width w of the contact channel 7"' from one lateral side 13 to the other lateral side 13, increases up to the bottom 29 of the channel 7"'. That is, the channel 7"' principally has a shape of a dovetail, as can be seen in Fig. 8. The lateral sides 13 of the contact channel 7"' are inclined with respect to the plane defined by the insertion direction I and the longitudinal direction L. Upon filling up the contact channel 7"' with the joining section 18 of the wire 2, the undercut 14 formed by the inclined lateral walls 13 forms a form-fit connection with the joining section 18 securing the part of the joining section 18 that is located in the contact channel 7"' against removal out of the channel 7"' against the insertion direction I.

Furthermore, the stopper 20 on the upper side 10 of the contact portion 5 that overlayers the entrance surface 9 is formed with a curved surface having, in the cross-sectional view, the form of a rivet head, rather than a flat, plate-like shape as in the embodiment of Fig. 1.

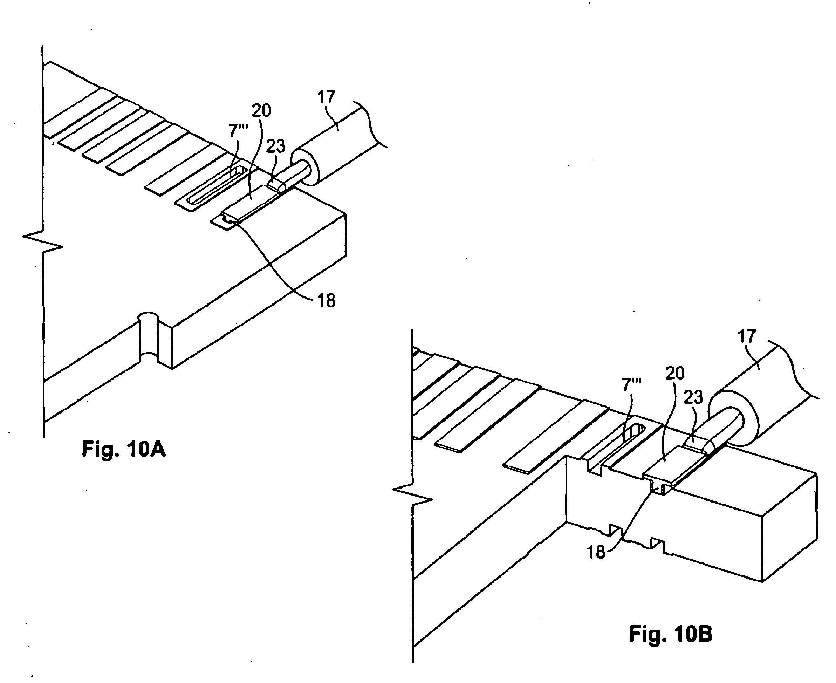

Finally, in Figs. 9, 10A and 10B, a further terminal assembly is shown. The wire 2 of this assembly is generally the same as the wire 2 used in the assembly of Figs. 1 to 3, namely a solid wire 2 having an insulating coating 17 that is removed in the connecting portion 8, where the conductor 16 is exposed to the outside.

The terminal element 3 in the assembly of Figs. 9, 10A, and 10B is a printed circuit board 30 having arranged on contact side 31 thereof, a series of spaced apart contact openings 7. As can be seen, for example, in Fig. 10B, the contact opening 7 of the PCB 30 is designed as contact channel 7"'. Contrary to the contact channel 7"' of the Fig. 8, however, the contact channels 7 of this assembly have the constant width w from the surface entrance 9 up to the bottom 28.

Upon contacting the connecting portion 8 of the wire 2 to the contact opening 7 of the PCB 30, the joining section 18 is pressed into the contact opening 7 forming a force-fit connection with the contact opening 7. The joining section 18 is filling up the complete channel 7 and the excess portion of the joining section 18 that remains outside the opening 7 is flattened into a stopper 20, whose shape principally corresponds to the stopper 20 located at the upper side 10 of the assembly shown in Fig. 1.

## Claims

1. Method for mechanically and electrically connecting an electric wire (2) to a terminal element (3) comprising: arranging a connecting portion (8) of the electric wire (2) substantially parallel to an entrance surface (9) of a contact opening (7) of said terminal element (3); and contacting a joining section (18) of the connecting portion (8) that is provided with an insulating coating (17) with the contact opening (7) by plastically deforming the joining section (18) into the contact opening (7), whereby the insulating coating (17) of the wire (2) is removed in the joining section (18) during contacting the joining section (18) with the contact opening (7), **characterized in that** the contact opening (7) is formed by a through-hole (7') extending from the entrance surface (9) on one side (10) of the terminal element (3) to an exit surface (11) on another side (12) of the terminal element (3), wherein the contact opening (7) is provided with at least one undercut (14) designed as at least one cavity (13) forming a dent, in which the contact opening (7) is widened and the insulation at the one side (10) is kept connected with the insulation at the other side (12).

2. Method of claim 1, **characterized in that** the contact opening (7) is elongated, whereby the connecting portion (8) of the electric wire (2) is arranged substantially parallel to the longitudinal direction (L) of the contact opening (7).

3. Method of claim 1 or 2, **characterized in that** the joining section (18) substantially fills up the contact opening (7) during the contacting.

4. Method of any one of claims 1 to 3, **characterized in that**, during contacting, the joining section (18) outside the contact opening (7) is overlaying the entrance surface (9).

5. Method of any one of claims 1 to 4, **characterized in that**, for contacting, the joining section (18) is pressed into the contact opening (7) in an insertion direction (I) that runs substantially perpendicular to the entrance surface (9) of the contact opening (7).

6. Terminal assembly (1) comprising a terminal element (3) having at least one contact opening (7), and at least one electric wire (2) that is provided with an insulating coating (17) and is mechanically and electrically connected to the contact opening (7), wherein a connecting portion (8) of the electric wire (2) that is located outside the contact opening (7) runs substantially parallel to an entrance surface (9) of the contact opening (7), and wherein a joining section (18) of the connecting portion (8) is plastically deformed into and thereby non-positively connected to the contact opening (7), wherein the insulating coating (17) of the wire (2) is removed in the joining section (18) during contacting the joining section (18) with the contact opening (7), **characterized in that** the contact opening (7) is formed by a through-hole (7') extending from the entrance surface (9) on one side (10) of the terminal element (3) to an exit surface (11) on another side (12) of the terminal element (3), wherein the contact opening (7) is provided with at least one undercut (14) designed as at least one cavity (13) forming a dent, in which the contact opening (7) is widened, and the insulation at the one side (10) is kept connected with the insulation at the other side (12).

7. Terminal assembly (1) according to claim 6, **characterized in that** the contact opening (7) is elongated in the direction of the electrical wire (2).

8. Terminal assembly (1) according to claim 6, **characterized in that** the joining section (18) extends through the through-hole (7') and is provided with a stopper (20) overlaying the entrance surface (9) at the upper side (10) and a further stopper (20a) overlaying the exit surface (11) on the lower side (12) of the terminal element (3).

9. Terminal assembly (1) according to any one of claims 6 to 8, **characterized in that** the wire (2) is a solid wire (2), a magnet wire (2') or a stranded wire (2").

10. Terminal assembly (1) according to any one of claims 6 to 9, **characterized in that** the volume of the wire (2) in the joining section (18) is greater than the volume of the contact opening (7).

11. Method for producing an electrical device comprising the method for mechanically and electrically connecting an electric wire (2) to a terminal element (3) according to anyone of claims 1 to 5.

12. Electrical device comprising a terminal assembly (1) according to anyone of claims 6 to 10.

## Patentansprüche

1. Verfahren zum mechanischen und elektrischen Verbinden einer elektrischen Leitung (2) mit einem Anschlusselement (3), wobei das Verfahren Folgendes umfasst:
das Anordnen eines Verbindungsabschnittes (8) der elektrischen Leitung (2) im Wesentlichen parallel zu einer Eintrittsfläche (9) einer Kontaktöffnung (7) des Anschlusselementes (3) und das In-Kontakt-Bringen einer Anschluss-Sektion (18) des Verbindungsabschnittes (8), der mit einer isolierenden Beschichtung (17) versehen ist, mit der Kontaktöffnung (7) durch das plastische Verformen der Anschluss-Sektion (18) in die Kontaktöffnung (7), wodurch die isolierende Beschichtung (17) der Leitung (2) in der Anschluss-Sektion (18) während des In-Kontakt-Bringens der Anschluss-Sektion (18) mit der Kontaktöffnung (7) entfernt wird, **dadurch gekennzeichnet, dass** die Kontaktöffnung (7) durch ein Durchgangsloch (7') gebildet wird, das sich von der Eintrittsfläche (9) auf einer Seite (10) des Anschlusselementes (3) bis zu einer Austrittsfläche (11) auf einer anderen Seite (12) des Anschlusselementes (3) erstreckt, wobei die Kontaktöffnung (7) mit wenigstens einer Hinterschneidung (14) versehen ist, die als wenigstens eine Höhlung (13) ausgelegt ist, die eine Ausbuchtung bildet, in der die Kontaktöffnung (7) geweitet ist und die Isolierung an der einen Seite (10) mit der Isolierung an der anderen Seite (12) verbunden gehalten wird.

2. Verfahren nach Anspruch 1, **dadurch gekennzeichnet, dass** die Kontaktöffnung (7) länglich ist, wodurch der Verbindungsabschnitt (8) der elektrischen Leitung (2) im Wesentlichen parallel zu der Längsrichtung (L) der Kontaktöffnung (7) angeordnet wird.

3. Verfahren nach Anspruch 1 oder 2, **dadurch gekennzeichnet, dass** die Anschluss-Sektion (18) während des In-Kontakt-Bringens die Kontaktöffnung (7) im Wesentlichen ausfüllt.

4. Verfahren nach einem der Ansprüche 1 bis 3, **dadurch gekennzeichnet, dass**, während des In-Kontakt-Bringens, die Anschluss-Sektion (18) außerhalb der Kontaktöffnung (7) die Eintrittsfläche (9) überdeckt.

5. Verfahren nach einem der Ansprüche 1 bis 4, **dadurch gekennzeichnet, dass**, zum In-Kontakt-Bringen, die Anschluss-Sektion (18) in einer Einfügungsrichtung (I), die im Wesentlichen senkrecht zu der Eintrittsfläche (9) der Kontaktöffnung (7) verläuft, in die Kontaktöffnung (7) gepresst wird.

6. Anschlussbaugruppe (1), die ein Anschlusselement (3), das wenigstens eine Kontaktöffnung (7) hat, und wenigstens eine elektrische Leitung (2), die mit einer isolierenden Beschichtung (17) versehen ist und mechanisch und elektrisch mit der Kontaktöffnung (7) verbunden ist, umfasst, wobei ein Verbindungsabschnitt (8) der elektrischen Leitung (2), der außerhalb der Kontaktöffnung (7) angeordnet ist, im Wesentlichen parallel zu einer Eintrittsfläche (9) der Kontaktöffnung (7) verläuft, und wobei eine Anschluss-Sektion (18) des Verbindungsabschnittes (8) plastisch in die Kontaktöffnung (7) verformt ist und dadurch kraftschlüssig mit der Kontaktöffnung (7) verbunden ist, wobei die isolierende Beschichtung (17) der Leitung (2) in der Anschluss-Sektion (18) während des In-Kontakt-Bringens der Anschluss-Sektion (18) mit der Kontaktöffnung (7) entfernt wird, **dadurch gekennzeichnet, dass** die Kontaktöffnung (7) durch ein Durchgangsloch (7') gebildet wird, das sich von der Eintrittsfläche (9) auf einer Seite (10) des Anschlusselementes (3) bis zu einer Austrittsfläche (11) auf einer anderen Seite (12) des Anschlusselementes (3) erstreckt, wobei die Kontaktöffnung (7) mit wenigstens einer Hinterschneidung (14) versehen ist, die als wenigstens eine Höhlung (13) ausgelegt ist, die eine Ausbuchtung bildet, in der die Kontaktöffnung (7) geweitet ist und die Isolierung an der einen Seite (10) mit der Isolierung an der anderen Seite (12) verbunden gehalten wird.

7. Anschlussbaugruppe (1) nach Anspruch 6, **dadurch gekennzeichnet, dass** die Kontaktöffnung (7) in der Richtung der elektrischen Leitung (2) länglich ist.

8. Anschlussbaugruppe (1) nach Anspruch 6, **dadurch gekennzeichnet, dass** sich die Anschluss-Sektion (18) durch das Durchgangsloch (7') erstreckt und mit einem Anschlag (20), der die Eintrittsfläche (9) an der oberen Seite (10) überdeckt, und einem weiteren Anschlag (20a), der die Austrittsfläche (11) auf der unteren Seite (12) des Anschlusselementes (3) überdeckt, versehen ist.

9. Anschlussbaugruppe (1) nach einem der Ansprüche 6 bis 8, **dadurch gekennzeichnet, dass** die Leitung (2) ein Volldraht (2), eine Spulenleitung (2') oder eine Litzenleitung (2") ist.

10. Anschlussbaugruppe (1) nach einem der Ansprüche 6 bis 9, **dadurch gekennzeichnet, dass** das Volumen der Leitung (2) in der Anschluss-Sektion (18) größer als das Volumen der Kontaktöffnung (7) ist.

11. Verfahren zum Herstellen eines elektrischen Gerätes, wobei das Verfahren das Verfahren zum mechanischen und elektrischen Verbinden einer elektrischen Leitung (2) mit einem Anschlusselement (3) nach einem der Ansprüche 1 bis 5 umfasst.

12. Elektrisches Gerät, das eine Anschlussbaugruppe (1) nach einem der Ansprüche 6 bis 10 umfasst.

## Revendications

1. Procédé de connexion mécanique et électrique d'un fil électrique (2) à un élément de raccordement (3), comprenant les étapes ci-dessous : agencement d'une partie de connexion (8) du fil électrique (2) de manière essentiellement parallèle à une surface d'entrée (9) d'une ouverture de contact (7) dudit élément de raccordement (3) ; et établissement d'un contact entre une section de liaison (18) de la partie de connexion (8) comportant un revêtement isolant (17) et l'ouverture de contact (7), par déformation plastique de la section de liaison (18) dans l'ouverture de contact (7), le revêtement isolant (17) du fil (2) étant ainsi retiré dans la section de liaison (18) au cours de l'établissement du contact entre la section de liaison (18) et l'ouverture de contact (7), **caractérisé en ce que** l'ouverture de contact (7) est formée par un trou de passage (7'), s'étendant de la surface d'entrée (9) sur un côté (10) de l'élément de raccordement (3) vers une surface de sortie (11) sur un autre côté (12) de l'élément de raccordement (3), l'ouverture de contact (7) comportant au moins une entaille (14) conçue sous forme d'au moins une cavité (13) formant un creux, dans lequel l'ouverture de contact (7) est élargie, et l'isolation au niveau dudit un côté (10) restant connectée à l'isolation au niveau de l'autre côté (12).

2. Procédé selon la revendication 1, **caractérisé en ce que** l'ouverture de contact (7) est allongée, la partie de connexion (8) du fil électrique (2) étant ainsi agencée de manière essentiellement parallèle à la direction longitudinale (L) de l'ouverture de contact (7).

3. Procédé selon les revendications 1 ou 2, **caractérisé en ce que** la section de liaison (18) remplit essentiellement l'ouverture de contact (7) au cours de l'établissement du contact.

4. Procédé selon l'une quelconque des revendications 1 à 3, **caractérisé en ce que**, au cours de l'établissement du contact, la section de liaison (18) située à l'extérieur de l'ouverture de contact (7) est superposée à la surface d'entrée (9).

5. Procédé selon l'une quelconque des revendications 1 à 4, **caractérisé en ce que**, en vue de l'établissement du contact, la section de liaison (18) est pressée dans l'ouverture de contact (7) dans une direction d'insertion (I), s'étendant de manière essentiellement perpendiculaire à la surface d'entrée (9) de l'ouverture de contact (7).

6. Assemblage de raccordement (1), comprenant un élément de raccordement (3) comportant au moins une ouverture de contact (7) ; et au moins un fil électrique (2) comportant un revêtement isolant (17) et connecté de manière mécanique et électrique à l'ouverture de contact (7), une partie de connexion (8) du fil électrique (2) situé à l'extérieur de l'ouverture de contact (7) s'étendant de manière essentiellement parallèle à une surface d'entrée (9) de l'ouverture de contact (7), une section de liaison (18) de la partie de connexion (8) étant soumise à une déformation plastique dans l'ouverture de contact (7), et étant ainsi connectée de manière non positive à celle-ci, le revêtement isolant (17) du fil (2) étant retiré dans la section de liaison (18) au cours de l'établissement du contact entre la section de liaison (18) et l'ouverture de contact (7), **caractérisé en ce que** l'ouverture de contact (7) est formée par un trou de passage (7'), s'étendant de la surface d'entrée (9) sur un côté (10) de l'élément de raccordement (3) vers une surface de sortie (11) sur un autre côté (12) de l'élément de raccordement (3), l'ouverture de contact (7) comportant au moins une entaille (14) conçue sous forme d'au moins une cavité (13) formant un creux, dans lequel l'ouverture de contact (7) est élargie, l'isolation au niveau dudit un côté (10) restant connectée à l'isolation au niveau de l'autre côté (12).

7. Assemblage de raccordement (1) selon la revendication 6, **caractérisé en ce que** l'ouverture de contact (7) est allongée dans la direction du fil électrique (2).

8. Assemblage de raccordement (1) selon la revendication 6, **caractérisé en ce que** la section de liaison (18) s'étend à travers le trou de passage (7') et comporte un obturateur (20), superposé à la surface d'entrée (9) au niveau du côté supérieur (10), et un obturateur additionnel (20a), superposé à la surface de sortie (11) sur le côté inférieur (12) de l'élément de raccordement (3).

9. Assemblage de raccordement (1) selon l'une quelconque des revendications 6 à 8, **caractérisé en ce que** le fil (2) est un fil massif (2), un fil magnétique (2') ou un fil toronné (2").

10. Assemblage de raccordement (1) selon l'une quelconque des revendications 6 à 9, **caractérisé en ce que** le volume du fil (2) dans la section de liaison (18) est supérieur au volume de l'ouverture de contact (7).

11. Procédé de production d'un dispositif électrique, comprenant le procédé de connexion mécanique et électrique d'un fil électrique (2) à un élément de raccordement (3) selon l'une quelconque des revendications 1 à 5.

12. Dispositif électrique, comprenant un assemblage de raccordement (1) selon l'une quelconque des revendications 6 à 10.
